# EUROPEAN PATENT APPLICATION

(11) **EP 1 632 887 A2**
(43) Date of publication of application: **08.03.2006**
(21) Application number: 05255373.2
(22) Date of filing: 02.09.2005
(51) Int. Cl.: G06K 19/077

(54) **SD/MMC Cards**

(30) Priority: 02.09.2004 US 933009
(71) Applicant: SYCHIP INC., Plano, Texas 75093 (US)
(72) Inventor: Chou, Wai Ping, Lewisville, TX 75067 (US); Sun, Kunquan, Plano, TX 75093 (US); Wang, Jiaxian, Frisco, TX 75035 (US); Yu, Yanbing, Plano, TX 75024 (US); Zhao, Meng, Plano, TX 75025 (US)
(74) Representative: Williams, David John

(57) **Abstract**

The specification describes PDA (SD/MMC) devices and PDA cards wherein the substrate on which the PDA components are mounted comprises two tiers. Components with a high profile are mounted on the lower tier, and devices with normal or low heights are mounted on the upper tier. The upper tier is contained in the portion of the card conforming to, for example, the 1.4 mm SDA standard thickness, while the lower tier is formed in the portion of the card that allows a larger thickness, for example SDA standard thickness 2.1 mm.

## Description

### Field of the Invention

This invention relates to memory and interface cards for portable computer devices such as personal digital assistants, digital cameras, etc. More specifically it relates to Secure Digital (SD) or Multimedia Memory Card (MMC) type cards that meet existing size standards but have enhanced component packing density.

### Background of the Invention

### (Portions of the technical material contained in this section may not be prior art.)

The evolution of component miniaturization in computer technology now allows very small, portable, units that can be carried as personal items, for example, in briefcases, or clothing pockets. There are a variety of such devices available commercially. Among those well known in the trade are PDAs, personal PCs, digital cameras, cell phones, smart phones, etc. For convenience, these portable devices are generically referred to below as PDAs. However, the term should be recognized as referring to any portable electronic device.

To extend the functional capacity of these devices, many have been equipped with slots to accommodate active integrated circuit cards. In so-called SD product technology these slots are designated Secure Digital or SD slots, and the cards as SD cards. When a unit is provided with I/O capability, the cards are referred to as SDIO cards.

A competing technology, MMC storage technology, uses very similar cards as storage media. In the description below, cards that are adapted for use with these technologies, and anticipated new technologies, will be referred to using the generic term "PDA cards".

In both of the established technologies just mentioned, standards have been established for the form factor of the cards. That allows manufacturers of the portable devices to have a common size and contact pin configuration for the slots in the portable units.

Both the SD standard and the MMC standard prescribe a length x width of 32 × 24 mm. The SD card thickness standard is 2.1 mm. The nominal MMC card thickness standard is 1.4 mm.

The complexity of the PDA cards and the portable units that use them increases as more functionality is added. These devices now provide audio, picture, video, and document storage capability. They can also interface with wireless LAN using SDIO interface cards. The SDIO card carries an RF integrated circuit. The other applications just mentioned are typically supported with large capacity memory circuits.

The combination of these circuits on a single PDA card presents a challenge for the PDA card designer. The length x width maximums place severe constraints on the design of the integrated circuits (ICs) in the PDA cards. Much of the effort toward more efficient component packing density has centered around these dimensions, i.e. the card area. For example, U.S. Patent Application Serial No. 10/839,901 describes and claims PDA card extensions where a portion of the card protrudes outside the slot. That portion has an unconstrained thickness, and various IC structures can be accommodated in the card extension portion.

However, we have recognized that the maximum height within the slot, and the corresponding maximum thickness of the portion of the PDA card contained within the slot, are also limiting. For example, a recent PDA application addition, plug-and-play network interfacing, uses cards having filters and oscillators that are large components, with a height typically in the 0.8-1.2 mm range. Recognizing that it is desirable for many applications to have most of the PDA card and the PDA ICs housed within the slot, and to meet the thickness standard, many versions of current PDA card configurations do not accommodate IC components with heights greater than approximately 0.8 mm.

### Summary of the Invention

We have designed a high density PDA integrated circuit card that overcomes in part the height constraint for IC components on the PDA card. We achieve this by building the printed circuit board platform on two levels. We have recognized that the contact pad end of the card should meet the 1.4 mm thickness maximum, while the remaining card portion is only constrained by the 2.1 mm thickness maximum. We take advantage of this difference by forming a tiered platform with two levels. The large IC components are placed on the lower tier of the two-tiered platform. Smaller components are placed on the upper tier. The upper tier portion of the card stays within the 1.4 mm constraint, and the lower tier portion stays within the 2.1 mm constraint. The tiers may comprise two printed circuit boards (PCBs), or a unitary PCB assembly having two tiers.

### Brief Description of the Drawings

Fig. 1 is a schematic view of a portion of a prior art PDA card illustrating the problem of insufficient height in the interior of the card to accommodate large IC components;
Fig. 2 is a view similar to that of Fig. 1 showing a tiered platform, according to one embodiment of the invention, that accommodates both large and small IC components;
Fig. 3 is a view similar to that of Fig. 2 showing electrical interconnections between the tiers;
Fig. 4 is a view similar to that of Fig. 2 showing a tiered platform comprising a unitary structure; and
Fig. 5 is a schematic representation of an alternative tiered PCB structure.

### Detailed Description

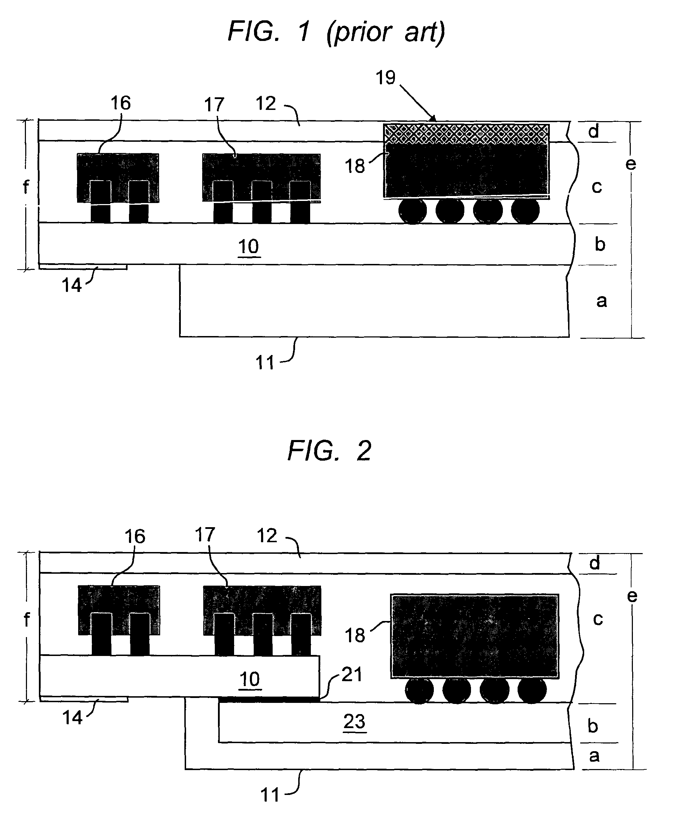

With reference to Fig. 1, a portion of a PDA card is shown with printed circuit board (PCB) 10, bottom plastic cover 11 and top plastic cover 12. The PDA card assembly is typically molded in a plastic encasement (usually the top and bottom covers), typically an epoxy or other tough polymer. Such encasements are well known in the art and widely used. Digital components and devices, such as capacitors, inductors, oscillators, filters, IC chips, etc., are mounted on the PCB. For devices with a wireless interface, for example an SDIO 802.11 b card, the card will have relatively large RF ICs and devices.

In Fig. 1, three components, 16, 17, and 18 are shown by way of example. Typically there are many more components on the PCB 10, iocated on the portion not shown. They may be mounted in a variety of ways, for example, surface mount, flip-chip ball grid array (BGA), etc. Contact fingers 14 are shown along the edge of the PDA card, typically on an exposed portion of the PCB as shown. The contact fingers have a standard size and configuration to fit the standard PDA slot.

The SD and MMC standards bodies have established standard dimensions for PDA cards. While these differ in some cases, dimension f in Fig. 1 is typically standardized at 1.4 mm. Dimension e may be larger, typically 2.1 mm, as in the SD Association standard. For the description below, the SDA standard will be assumed.

In a typical PDA card, dimensions a, b, c, and d, are 0.7 mm, 0.4 mm, 0.8 mm, 0.2 mm, for a total dimension e that meets the SDA maximum of 2.1 mm. The space for components has a height c = 0.8 mm. That is sufficient to accommodate devices 16 and 17, but device 18 has a height that exceeds the height of the allowed space at 19.

In some PDA cards, the thickness of the PCB may be less than 0.4 mm. That may allow sufficient space for device 19. However, as PDAs accumulate more and more functionality, the PCB becomes more complex, and thicker multilayer PCBs are needed. This increases the constraint on dimension c in the PDA card.

To overcome this problem according to the invention, a new PCB configuration is used. This is shown in Fig. 2, where the PCB is tiered. The difference between the 1.4 mm end section, where the contact fingers are located, and the remaining PDA card section, where the SDA standard allows a 2.1 mm thickness, permits a second PCB tier to be constructed. In Fig. 2 the PCB is shown with first tier 21 in the 1.4 mm section, and second tier 23 in the 2.1 mm section. It should be understood that the drawings are not necessarily to scale. In the embodiment shown in Fig. 2, two separate PCBs are shown, and these are fastened together with a suitable bonding layer, such as solder layer 25. The overlap provides strength to the tiered PCB. A wide variety of methods may occur to those skilled in the art to attach the tiers of the PCB together.

In the embodiment of Fig. 2, the set-off, i.e. the distance between the surface of tier 1 and the surface of tier 2, is determined by the thickness of PCB 21. That set-off can be varied if desired using a different method of joining the PCBs. If the PCBs are joined end-to-end, any value for the set-off can be chosen. If a set-off larger than that shown in Fig. 2, i.e. larger than the thickness of the upper PCB, is desired, a spacer can be inserted at the joint 25.

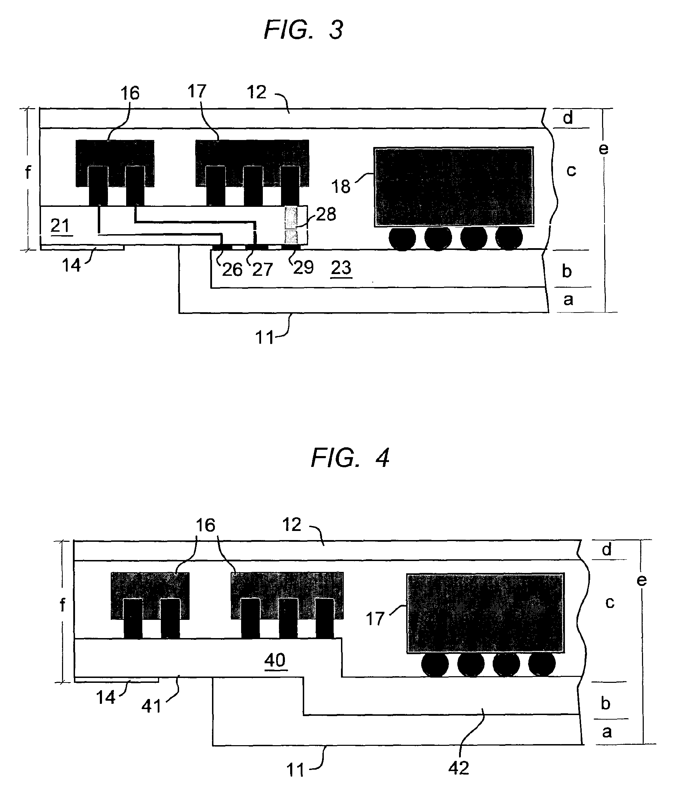

The tiers of the PCB are physically attached as already shown, and are also electrically interconnected. Again, a variety of approaches may be used to run electrical interconnections between the tiers. Plated through holes, well known in the art, may be used to interconnect a metallization pattern on PCB 21, to contact pads on PCB 23. Recognizing that the PCBs may be multilevel, it is straightforward to route interconnect runners out of both sides of a PCB. This expedient is illustrated in Fig. 3, where PCB 21 is a multilevel PCB, and device 16 is interconnected on one level of PCB 21 to contact pad 26 on PCB 23, and on another level to contact pad 27. A plated through hole interconnection between device 17 and PCB 23 is represented by 28, 29. These interconnection schemes are shown simply to demonstrate some suitable interconnection techniques. In this embodiment of the invention the contact pads used for the interconnections, i.e. pads 26, 27, and 29, may also be used to attach the PCBs 21 and 23. Auxiliary attachments may be used in addition. Another approach (not shown) is to run conductor strips over the edge of PCB 21.

Fig. 4 shows an alternative embodiment of the invention wherein the tiered PCB 40 is a unitary structure with upper tier 41 and lower tier 42. This PCB structure has several advantages. It can be molded of polymer resin as a unitary body, thus having superior mechanical strength. It can also be multilevel, removing the need for the interconnections between PCBs 21 and 23 as shown in Fig. 3. Unitary body as used herein is a term that describes a body, usually a polymer body, that is molded in one piece. Yet another advantage of the PCB structure of Fig. 3 is that the set-off, i.e. the distance between the surface of tier 1 and the surface of tier 2 may be made independent of the thickness of the upper PCB.

To realize the benefits of the invention, the tiers should have a significant separation, i.e. height difference. In the context of the dimensions in the current state of the art, a significant advantage may be gained by dropping the lower tier of the PCB by at least 0.1 mm. Moreover, the benefit of the invention is realized when the height of a component on the lower tier exceeds the available height, i.e. dimension c, on the upper tier. It will also be the case that at least one component mounted on the lower tier has a thickness that exceeds the thickness of all of the components on the upper tier.

The PDA card of the invention may be designed to be fully contained in the slot of the PDA device, or may have an extension of the kind described in copending application Serial No. 10/839,901, which application is incorporated herein by reference. In common commercial PDA card designs, the card is longer than the PDA slot, with a portion of the card extending outside the PDA housing. The extension of the PDA card facilitates handling for inserting and extracting the card. In cards designed with a wireless LAN interface, the extended portion of the card may contain an encased RF circuit and an RF antenna.

Whereas the standard PCBs are epoxy resin, for example, FR-4, other PCB types may be used as well. A flexible polymer PCB may be used which, in some cases, may be flexed to provide the two-tiered structure shown in Fig. 4. Alternatively, it may be a ceramic or silicon interconnect substrate. Generically, these are referred to here as PCB.

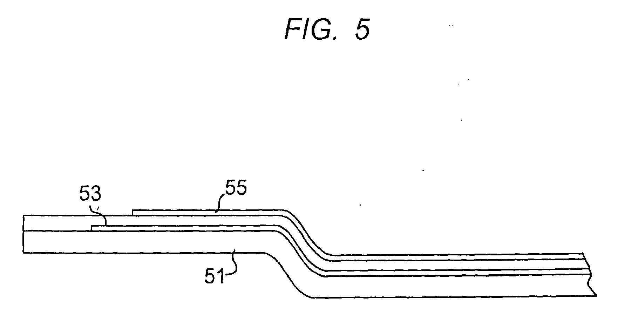

A particularly useful embodiment of the invention is shown in Fig. 5. For simplicity, Fig. 5 shows only the tiered PCB structure. Element 51 is a relatively rigid substrate, advantageously the bottom cover of the PDA card (e.g. 11 in Fig. 4). Attached to the substrate is a thin, flexible, printed circuit sheet 52, having conductor patterns 53 and 55 on the top and bottom of the sheet respectively.

The PDA cards described above typically contain one or more IC chips with active devices, e.g. RF chips or memory chips. it also typically has passive components, and/or one or more integrated passive devices (IPDs). The active IC chips, and the passive devices, are referred to by the generic term component(s).

From the foregoing description, it should be evident that according to one embodiment of the invention, a PDA card comprises a first PCB portion with a bottom plastic cover having thickness a₁, a PCB having thickness b₁, a component space having thickness c₁ and a top cover having thickness d₁, where a₁+ b₁+ c₁ + d₁ = e₁, and a second PCB portion having a bottom plastic cover having thickness a₂, a PCB having thickness b₂, a component space having thickness c₂ and a top cover having thickness d₂, where a₂+ b₂+ c₂ + d₂ = e₂, and wherein e₁ is greater than e₂, and e₁ and e₂ are made to conform to an industry standard. It will also be appreciated that whereas at least one of a₁+ b₁+ c₁ + d₁ is different from the respective member of a₂+ b₂+ c₂ + d₂, others may be the same.

The invention may also be described in terms of the height of the components accommodated by the two tiered PCB. That would be described by a printed circuit board (PCB) having two tiers, a first tier at one level and a second tier at a different level, a cover overlying the PCB forming a first space with height C₁ over the first tier and a second space with height C₂ over the second tier, where C₁ is greater than C₂, at least one component attached to the PCB in the first space, the component having a height h₁, at least one component attached to the PCB in the second space, the component having a height h₂ where h₁ > c₂.

Various additional modifications of this invention will occur to those skilled in the art. All deviations from the specific teachings of this specification that basically rely on the principles and their equivalents through which the art has been advanced are properly considered within the scope of the invention as described and claimed.

## Claims

1. A PDA card comprising:
a. a printed circuit board (PCB) having two tiers, a first tier at one level and a second tier at a different level,
b. a cover overlying the PCB forming a first space with height c₁ over the first tier and a second space with height c₂ over the second tier, where c₁ is greater than c₂,
c. at least one component attached to the PCB in the first space, the component having a height h₁,
c. at least one component attached to the PCB in the second space, the component having a height h₂, where h₁ > c₂.
e. at least one electrical conductor interconnecting the component in the first space with the component in the second space.
e. an encapsulant encapsulating a., b., c., d. and e.

2. The PDA card of claim 1 wherein c₁ is greater than (c₂ + 0.1 mm).

3. The PDA card of claim 1 wherein the PCB comprises a unitary body.

4. A PDA card comprising:
a. an upper tier printed circuit board (PCB) having a top surface, a bottom surface, a width W₁ and length L₁, the upper tier PCB mounted on a first level,
b. a lower tier PCB having a top surface, a bottom surface, a width W₂ and length L₂, the lower tier PCB mounted on a second level, with a portion of L₁ overlapping a portion of L₂,
c. a cover overlying the lower tier PCB and the upper tier PCB forming a first space with height C₁ over the lower tier PCB and a second space with height c₂ over the upper tier PCB, where C₁ is greater than c₂,
d. at least one upper tier component attached to the top surface of the upper tier PCB,
e. at least one lower tier component with height h attached to the top surface of the lower tier PCB, where h is greater than c₂,
f. at least one electrical conductor interconnecting the component attached to the top surface of the upper tier PCB and the component attached to the top surface of the lower tier PCB
g. an encapsulant encapsulating both the upper tier PCB and the lower tier PCB.

5. The PDA card of claim 4 wherein the upper PCB is attached to the lower PCB at the portion of L₁ overlapping a portion of L₂.

6. The PDA card of claim 4 wherein the upper PCB is attached to the lower PCB by solder.

7. The PDA card of claim 5 wherein the upper PCB has a thickness greater than 0.1 mm.

8. The PDA card of claim 4 wherein h > c₁ + 0.1 mm.

9. A PDA card comprising a first PCB portion with a bottom plastic cover having thickness a₁, a PCB having thickness b₁, a component space having thickness c₁ and a top cover having thickness d₁, where a₁+ b₁+ c₁ + d₁ = e₁, and a second PCB portion having a bottom plastic cover having thickness a₂, a PCB having thickness b₂, a component space having thickness c₂ and a top cover having thickness d₂, where a₂+ b₂+ c₂ + d₂ = e₂, and wherein e₁ is greater than e₂, and e₁ and e₂ are made to conform to an industry standard.

10. The PDA card of claim 9 wherein e₂ is approximately 1.4 mm.

11. The PDA card of claim 10 wherein e₁ is approximately 2.1 mm.

12. The PDA card of claim 9 wherein the first PCB portion and the second PCB portion comprise a unitary body.

13. The PDA card of claim 12 wherein the unitary body is a multilevel PCB.

14. The PDA card of claim 12 wherein the unitary body is an epoxy PCB molded to have two tiers.

15. The PDA card of claim 12 wherein the bottom plastic cover is molded with two tiers.

16. The PDA card of claim 15 wherein the unitary body is a flexible printed circuit that conforms to the two tiers of the bottom plastic cover.
